# EUROPEAN PATENT APPLICATION

(11) **EP 4 195 220 A1**
(43) Date of publication of application: **14.06.2023**
(21) Application number: 21213290.6
(22) Date of filing: 09.12.2021
(51) Int. Cl.: G21C 3/07, G21C 21/00

(54) **A NUCLEAR FUEL ROD CLADDING TUBE AND A METHOD FOR MANUFACTURING A NUCLEAR FUEL ROD CLADDING TUBE**

(71) Applicant: Westinghouse Electric Sweden AB, 721 63 Västerås (SE)
(72) Inventor: WRIGHT, Jonathan, Västerås (SE); LIMBÄCK, Magnus, Västerås (SE); ADORNO LOPES, Denise, Västerås (SE); NORLÉN, Magnus, Västerås (SE)
(74) Representative: Bjerkén Hynell KB

(57) **Abstract**

A nuclear fuel rod cladding tube (1, 1') is described. The nuclear fuel cladding tube has an oxidation resistant coating of Chromium-Niobium Nitride (Cr-Nb-N). A method for manufacturing a nuclear fuel rod cladding tube (1, 1') is also described.

## Description

### Technical field,

The present disclosure relates to nuclear fuel rod cladding tubes and more particularly to nuclear fuel rod cladding tubes with an outer coating. The present disclosure also relates to a method for manufacturing a nuclear fuel rod cladding tube.

### Background

In a typical nuclear reactor, the reactor core includes a large number of fuel assemblies, each of which is composed of a plurality of elongated fuel rods. The fuel rods each contain nuclear fuel fissile material, usually in the form of a stack of nuclear fuel pellets surrounded by a gas, such as He. The fuel rods have a cladding that acts as a containment for the fissile material.

Light Water Reactors (LWRs) use water as a coolant and as a neutron moderator. There are two basic types of LWRs, Pressurized Water Reactors (PWRs) and Boiling Water Reactors (BWRs). Water-Water Energetic Reactors (VVERs) can be considered as a type of PWR. Small Modular Reactors (SMRs) can also be of LWR type. In LWRs, the fuel rod cladding tubes are typically made of a zirconium based alloy.

WO2021/112938 describes a nuclear fuel rod cladding tube with an outer coating comprising an intermediate layer of Nb.

WO2018/067425 describes forming duplex layers on a nuclear fuel rod cladding tube. The duplex layer comprises an inner interlayer and an outer corrosion resist layer.

WO2020/018361 describes a nuclear fuel rod cladding tube with a ceramic yarn wound around the tube and bonded with a coating.

One issue with hard facing coatings on fuel cladding materials that have been developed to counteract fuel failure from debris fretting is the stability of these coatings under conditions which prevail inside the core of, for example, a BWR.

Therefore, there is a need of an improved coating of nuclear fuel rod cladding tubes.

Thus, one object of the present invention is to provide an improved nuclear fuel rod cladding tube regarding, i.a. stability and protection from debris fretting. A further object of the present invention is to achieve a method for manufacturing an improved nuclear fuel rod cladding tube.

### Summary

The above-mentioned objects are achieved by the present invention according to the independent claims.

Preferred embodiments are set forth in the dependent claims.

According to one aspect, the present invention relates to a nuclear fuel rod cladding tube having an oxidation resistant coating of Chromium-Niobium Nitride (Cr-Nb-N). The oxidation resistant coating consists of Cr-Nb-N.

Because Niobium (Nb) is present in the coating together with Chromium-Nitride (Cr-N), the oxidation of Cr-N can be stabilized and the coating can be more protective (via formation of stabilized Cr₂O₃) in contrast to, for example, the non-protective oxidation of pure Cr system with formation of CrOx in, for example, BWR conditions. Thus, a nuclear fuel rod cladding tube is achieved having an improved oxidation resistance compared to fuel rod cladding tubes known in the art.

Further, the oxidation resistant coating of Cr-Nb-N provides a surface with a higher hardness, in comparison with non-coated or Cr-coated fuel claddings tubes, and therefore demonstrates adequate debris protection in, for example, BWR environments.

The addition of Nb to Cr, not only increases the oxidation resistance but also, leads to a lower total neutron cross-section. This advantage can be harvested either as a lower neutron absorption or for allowing a thicker coating, if additional protection is deemed advantageous.

Consequently, a nuclear fuel rod cladding tube is provided having an improved oxidation resistance and improved debris protection compared to rod cladding tubes known in the art. Therefore, the above mentioned object is achieved.

Optionally, the oxidation resistant coating is configured as a monolayer. Having a mono layer ensures consistent performance throughout the layer with respect to corrosion and is the simplest, therefore likely cheapest coating to manufacture.

Optionally, the oxidation resistant coating is configured as a multiple layers coating. Multiple layers can combine advantageous properties of both layer components. Further, the interface between layers can act to divert cracks. The interfaces between layers can also allow some extent of sliding over each other maintaining from a larger perspective an intact layer. Multiple layers coating can be called multilayer coating.

Optionally, the oxidation resistant coating is configured as a nanoscale multilayer coating, such as a Chromium Nitride/Niobium Nitride (CrN/NbN) - superlattice. The layers in a superlattice contribute to yet improved characteristics regarding the oxidation resistance and debris protection of the fuel rod cladding tube.

Optionally, the content of the Niobium in the Cr-Nb-N is between 5 at% and 90 at%, preferably between 5 at% and 50 at% and most preferably between 5 at% and 35 at%.

Optionally, the oxidation resistant coating has a thickness between 1 µm and 30 µm, preferably between 2 µm and 15 µm and most preferably between 4 µm and 12 µm. Thus, in case of the oxidation resistant coating configured as a multilayer coating the thickness is the total thickness of the coating.

Optionally, the nuclear fuel rod cladding tube is adapted for use in a Boiling Water Reactor (BWR). As an alternative the nuclear fuel rod cladding tube can be used in other types of Light Water Reactors (LWRs), such as Pressurized Water Reactors (PWRs), Water-Water Energetic Reactors (VVERs), and Small Modular Reactors (SMRs).

According to a further aspect, the present invention relates to a method for manufacturing a nuclear fuel rod cladding tube, wherein the method comprises the following steps:
- providing a nuclear fuel rod cladding tube base and
- providing an oxidation resistant coating of Chromium-Niobium Nitride (Cr-Nb-N) on the tube base. The oxidation resistant coating consists of Cr-Nb-N.

Because Niobium (Nb) is present in the coating together with Chromium-Nitride (Cr-N), the oxidation of Cr-N can be stabilized and the coating can be more protective (via formation of stabilized Cr₂O₃) in contrast to, for example, the non-protective oxidation of pure Cr system with formation of CrOx in, for example, BWR conditions. Thus, a nuclear fuel rod cladding tube is achieved having an improved oxidation resistance compared to rod cladding tubes known in the art.

Further, the oxidation resistant coating of Cr-Nb-N provides a surface with a higher hardness, in comparison with non-coated or Cr-coated fuel claddings tubes, and therefore demonstrates adequate debris protection in, for example, BWR environments.

The addition of Nb to Cr, not only increases the oxidation resistance but also, leads to a lower total neutron cross-section. This advantage can be harvested either as a lower neutron absorption or for allowing a thicker coating, if additional protection is deemed advantageous.

Consequently, a method for manufacturing an improved nuclear fuel rod cladding tube is provided, by which method a nuclear fuel rod cladding tube is provided having an improved oxidation resistance and improved debris protection compared to fuel rod cladding tubes known in the art. Therefore, the above mentioned object is achieved.

Optionally, the oxidation resistant coating is configured as a monolayer. Having a mono layer ensures consistent performance throughout the layer with respect to corrosion and is the simplest, therefore likely cheapest coating to manufacture.

Optionally, the oxidation resistant coating is configured as a multiple layers coating. A multiple layers coating can combine advantageous properties of both layer components. Further, the interface between layers can act to divert cracks. The interfaces between layers can also allow some extent of sliding over each other maintaining from a larger perspective an intact layer. Multiple layers coating can be called multilayer coating.

Optionally, the oxidation resistant coating is configured as a nanoscale multilayer, such as Chromium Nitride/Niobium Nitride (CrN/NbN) - superlattice. The layers in a superlattice contribute to yet improved characteristics regarding the oxidation resistance and debris protection of the fuel rod cladding tube.

Optionally, the coating of the Chromium-Niobium Nitride (Cr-Nb-N) is achieved by a Physical Vapor Deposition (PVD) process. Thus, the coating can be achieved in an effective and reliable way.

Optionally, the content of the Niobium in the Cr-Nb-N is between 5 at% and 90 at%, preferably between 5 at% and 50 at% and most preferably between 5 at% and 35 at%.

Optionally, the oxidation resistant coating has a thickness between 1 µm and 30 µm, preferably between 2 µm and 15 µm and most preferably between 4 µm and 12 µm. Thus, in case of the oxidation resistant coating configured as a multilayer coating the thickness is the total thickness of the coating.

### Brief description of the drawings

Fig. 1 illustrates results of simulations of surface appearance of Cr-Nb-N and Cr-N coatings.
Fig.2 is a cross sectional view through a schematically illustrated nuclear fuel rod cladding tube with an oxidation resistant coating configured as a monolayer.
Fig. 3 is a cross sectional view through a schematically illustrated nuclear fuel rod cladding tube with an oxidation resistant coating configured as a multiple layers coating.
Fig. 4 is a cut view of a schematic fuel assembly for a BWR reactor comprising a nuclear fuel rod cladding tube according to an embodiment.
Fig. 5 is a cut view of a schematic fuel assembly for a PWR reactor comprising a nuclear fuel rod cladding tube according to an embodiment.

### Detailed description

The invention will now be described in detail with references to the appended figures. Throughout the figures the same, or similar, items have the same reference signs. Moreover, the items and the figures are not necessarily to scale, emphasis instead being placed upon illustrating the principles of the invention.

Niobium, also known as columbium, is a chemical element with the symbol Nb (formerly Cb) and atomic number 41. Niobium is a light grey, crystalline, and ductile transition metal. Pure niobium has a Mohs hardness rating similar to that of pure titanium and it has similar ductility to iron. Niobium oxidizes very slowly in the earth's atmosphere.

According to one aspect, the present invention relates to a nuclear fuel rod cladding tube 1, 1' having an oxidation resistant coating 5, 5' of Chromium-Niobium Nitride (Cr-Nb-N).

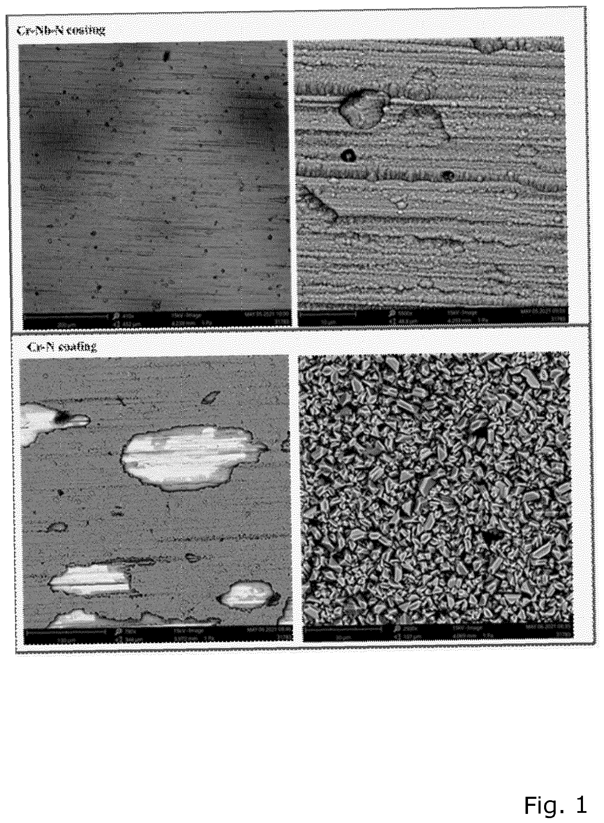

Because Niobium (Nb) is present in the coating together with Chromium-Nitride (Cr-N), the oxidation of Cr-N can be stabilized and can be more protective via formation of stabilized Cr₂O₃, in contrast to, for example, the non-protective oxidation of pure Cr system with formation of CrOx in, for example, BWR conditions. Several simulations have been performed and the appended Fig. 1 illustrates results of simulations of surface appearance of Cr-Nb-N and Cr-N coatings after 60 days exposure in an autoclave simulating BWR conditions. As can be seen in Fig. 1, the Cr-Nb-N coating has a smooth and stable surface after 60 days exposure and thereby provides both improved corrosion resistance and an improved protection against debris.

The Cr-Nb-N coating can be achieved by a Physical Vapor Deposition (PVD) process using multiple targets of Cr and Nb or by pre-production of Cr-Nb alloy targets with the selected composition, followed in both cases by deposition in an N₂ atmosphere.

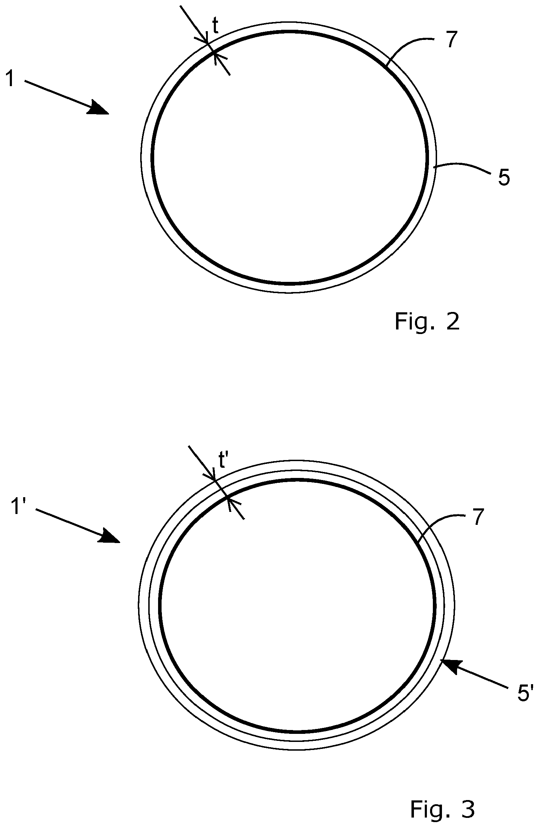

The appended figures Fig.2-Fig. 5 will now be described. Fig. 2 is a cross sectional view through a schematically illustrated nuclear fuel rod cladding tube 1 with an oxidation resistant coating 5 configured as a monolayer. The nuclear fuel rod cladding tube 1 comprises a nuclear fuel cladding tube base 7 and the oxidation resistant coating 5, which coating 5 is of Chromium-Niobium Nitride (Cr-Nb-N). The thickness of the nuclear fuel cladding tube base 7 is typically around 0.5-0.8 mm (500-800 µm). The nuclear fuel cladding tube base 7 is preferably made of a zirconium based alloy. The coating 5 consist of Cr-Nb-N. The oxidation resistant coating 5 have a thickness t between 1 µm and 30 µm, preferably between 2 µm and 15 µm and most preferably between 4 µm and 12 µm. Thus, the oxidation resistant coating 5 is much thinner than the nuclear fuel cladding tube base 7. The content of the Niobium in the Cr-Nb-N is between 5 at% and 90 at%, preferably between 5 at% and 50 at% and most preferably between 5 at% and 35 at%. The nuclear fuel cladding tube base 7 may be coated by the oxidation resistant coating 5 using a Physical Vapor Deposition (PVD) process. The principle of a PVD-process is a common knowledge and is therefore not described in details herein.

Fig. 3 is a cross sectional view through a schematically illustrated nuclear fuel rod cladding tube 1' with an oxidation resistant coating 5' configured as a multiple layers coating. Multiple layers coating can be called multilayer coating. According to the embodiments illustrated in Fig. 3, the oxidation resistant coating 5'comprises two layers. However, the oxidation resistant coating 5'may comprise a multitude of very thin layers, instead of just two layers. The nuclear fuel rod cladding tube 1' comprises a nuclear fuel cladding tube base 7 and the oxidation resistant coating 5' with multiple layers, wherein each layer of the multiple layers is of Chromium-Niobium Nitride (Cr-Nb-N). According to the embodiments illustrated in Fig. 3, the nuclear fuel cladding tube base 7 is as the nuclear fuel cladding tube base 7according to the embodiments illustrated in Fig. 2. Thus, the thickness of the nuclear fuel cladding tube base 7 is typically around 0.5-0.8 mm (500-800 µm). The nuclear fuel cladding tube base 7 is preferably made of a zirconium based alloy. Each layer of the coating 5' consist of Cr-Nb-N. The coating 5'have a thickness t' between 1 µm and 30 µm, preferably between 2 µm and 15 µm and most preferably between 4 µm and 12 µm. Thus, the oxidation resistant coating 5' configured as a multilayer coating has the total thickness t' between 1 µm and 30 µm, preferably between 2 µm and 15 µm and most preferably between 4 µm and 12 µm. Thus, the oxidation resistant coating 5' is much thinner than the nuclear fuel cladding tube base 7. The thickness of each layer of the coating 5' may be the same or the thicknesses may differ between the layers of the coating 5'. The content of the Niobium in the Cr-Nb-N in each layer is between 5 at% and 90 at%, preferably between 5 at% and 50 at% and most preferably between 5 at% and 35 at%. The nuclear fuel cladding tube base 7 may be coated by the oxidation resistant coating 5'using a Physical Vapor Deposition (PVD) process, i.e. each layer of the coating 5' can be achieved by a PVD-process. The principle of a PVD-process is a common knowledge and is therefore not described in details herein.

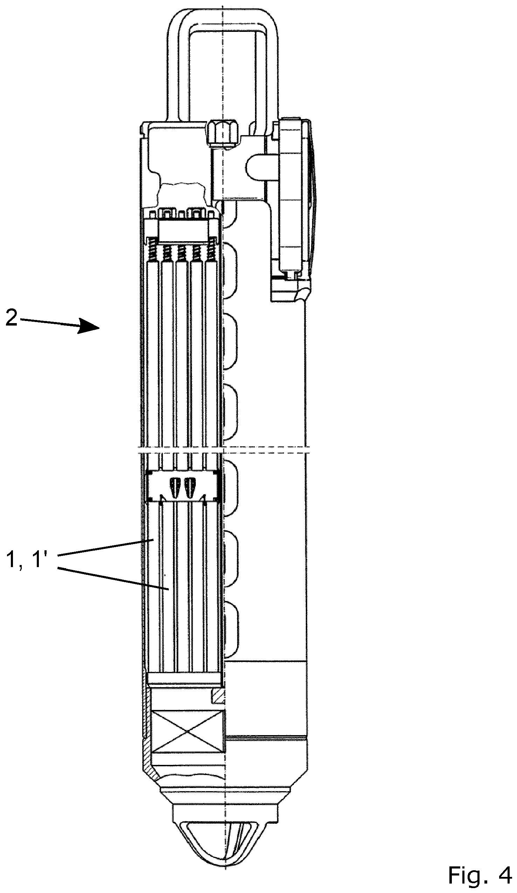

Fig. 4 is a cut view of a schematic fuel assembly for a BWR reactor 2 comprising a nuclear fuel cladding rod tube 1, 1' according to an embodiment of the invention described herein.

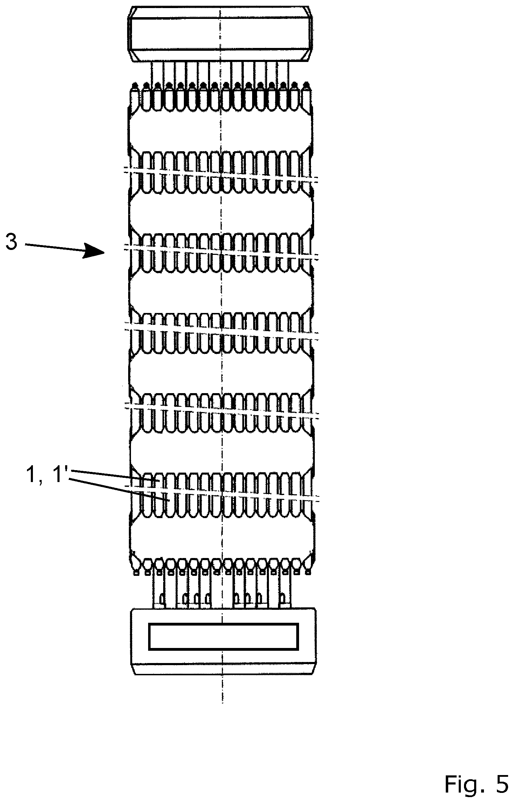

Fig. 5 is a cut view of a schematic fuel assembly for a PWR reactor 3 comprising a nuclear fuel cladding rod tube 1, 1' according to an embodiment of the invention described herein.

The nuclear fuel rod cladding tube 1, 1' according to the present invention, can also be arranged in a Light Water Reactor (LWR), a Water-Water Energetic Reactor (VVER) or a Small Modular Reactor (SMR).

The present invention is not limited to the above-described preferred embodiments. Various alternatives, modifications and equivalents may be used. Therefore, the above embodiments should not be taken as limiting the scope of the invention, which is defined by the appending claims.

## Claims

1. A nuclear fuel rod cladding tube (1, 1'), **characterized in that** the nuclear fuel rod cladding tube (1, 1') has an oxidation resistant coating (5, 5') of Chromium-Niobium Nitride (Cr-Nb-N).

2. The nuclear fuel rod cladding tube (1) according to claim 1, wherein the oxidation resistant coating (5) is configured as a monolayer.

3. The nuclear fuel rod cladding tube (1') according to claim 1, wherein the oxidation resistant coating (5') is configured as a multiple layers coating.

4. The nuclear fuel rod cladding tube (1') according to claim 3, wherein the oxidation resistant coating (5') is configured as a nanoscale multilayer coating, such as a Chromium Nitride/Niobium Nitride (CrN/NbN) - superlattice.

5. The nuclear fuel rod cladding tube (1, 1') according to any of claims 1 to 4, wherein the content of the Niobium in the Cr-Nb-N is between 5 at% and 90 at%, preferably between 5 at% and 50 at% and most preferably between 5 at% and 35 at%.

6. The nuclear fuel rod cladding tube (1, 1') according to any of claims 1 to 5, wherein the oxidation resistant coating (5, 5') has a thickness (t, t') between 1 µm and 30 µm, preferably between 2 µm and 15 µm and most preferably between 4 µm and 12 µm.

7. The nuclear fuel rod cladding tube (1, 1') according to any of claims 1 to 6, wherein the nuclear fuel rod cladding tube (1) is adapted for use in a Boiling Water Reactor (BWR).

8. , A method for manufacturing a nuclear fuel rod cladding tube (1, 1'), wherein the method comprises the following steps:
- providing a nuclear fuel cladding tube base (7) and
- providing an oxidation resistant coating (5, 5') of Chromium-Niobium Nitride (Cr-Nb-N) on the tube base.

9. The method according to claim 8, wherein the oxidation resistant coating (5) is configured as a monolayer.

10. The method according to claim 8, wherein the oxidation resistant coating (5') is configured as a multiple layers coating.

11. The method according to claim 10, wherein the oxidation resistant coating (5') is configured as a nanoscale multilayer coating, such as Chromium Nitride/Niobium Nitride (CrN/NbN) - superlattice.

12. The method according to any of claims 8 to 11, wherein the oxidation resistant coating (5, 5') of Cr-Nb-N is achieved by a Physical Vapor Deposition (PVD) process.

13. The method according to any of claims 8 to 12, wherein the content of the Niobium in the Cr-Nb-N is between 5 at% and 90 at%, preferably between 5 at% and 50 at% and most preferably between 5 at% and 35 at%.

14. The method according to any of claims 8 to 13, wherein the oxidation resistant coating (5, 5') has a thickness (t, t') between 1 µm and 30 µm, preferably between 2 µm and 15 µm and most preferably between 4 µm and 12 µm.
